**Europäisches Patentamt**

**European Patent Office**

**Office européen des brevets**

(19)

(11) Veröffentlichungsnummer : **0 396 581 B1**

(12) # EUROPÄISCHE PATENTSCHRIFT

(45) Veröffentlichungstag der Patentschrift :
**15.01.92 Patentblatt 92/03**

(51) Int. Cl.$^5$ : **H01L 39/24**

(21) Anmeldenummer : **89900190.3**

(22) Anmeldetag : **13.12.88**

(86) Internationale Anmeldenummer :
**PCT/DE88/00763**

(87) Internationale Veröffentlichungsnummer :
**WO 89/06053 29.06.89 Gazette 89/14**

(54) **VERFAHREN ZUR HERSTELLUNG VON DRÄHTEN ODER BÄNDERN AUS HOCHTEMPERATUR-SUPRALEITERN UND DABEI VERWENDETER HÜLLKÖRPER.**

(30) Priorität : **15.12.87 DE 3742499**

(43) Veröffentlichungstag der Anmeldung :
**14.11.90 Patentblatt 90/46**

(45) Bekanntmachung des Hinweises auf die
Patenterteilung :
**15.01.92 Patentblatt 92/03**

(84) Benannte Vertragsstaaten :
**CH DE FR GB IT LI NL**

(56) Entgegenhaltungen :
**EP-A- 0 281 474**
**EP-A- 0 282 286**
**EP-A- 0 285 319**
**EP-A- 0 290 331**
**Japanese Journal of Applied Physics, Teil 2,
Band 26, Suppl. 26-3, 1987,(Tokio,JP), K. Ohmatsu et al.: "Superconducting wires of high
Tc oxides", Seiten 1207-1208 siehe Seite 1207,
linke Spalte, Absatz 2- rechte Spalte, Absatz1**

(56) Entgegenhaltungen :
**Japanese Journal of Applied Physics, band
26, Nr.5, Mai 1987, O.Kohno et al.: " Critical
temperature and critical current density of
La-Sr-Cu oxide wires", Seiten L759-L760 siehe
das ganze Dokument**

(73) Patentinhaber : **SIEMENS
AKTIENGESELLSCHAFT
Wittelsbacherplatz 2
W-8000 München 2 (DE)**

(72) Erfinder : **GUNZELMANN, Karl-Heinz
Händelstr. 12
W-8500 Nürnberg (DE)**
Erfinder : **MÜLLER, Reiner
Estrada das Piscinas Nr. 12
P-7000 Evora (PT)**
Erfinder : **HERKERT, Werner
Wichernstr. 18
W-8520 Erlangen (DE)**
Erfinder : **GROSSE, Joachim
In der Reuth 126
W-8520 Erlangen (DE)**
Erfinder : **TIEFEL, Günter
Ligusterweg 22
W-8510 Fürth (DE)**

## Beschreibung

Die Erfindung bezieht sich auf ein Verfahren zur Herstellung von Drähten oder Bändern aus Hochtemperatur-Supraleitern, wobei aus oxidischen Pulvern durch Mischen, Pressen, Sintern und Mahlen sowie thermische Behandlung ein supraleitendes Material hergestellt wird, das durch Formgebung auf den gewünschten Querschnitt gebracht wird. Gegebenenfalls kann die thermische Behandlung auch schmelzmetallurgische Schritte einschließen. Daneben bezieht sich die Erfindung auch auf den insbesondere für das Strangpressen notwendigen Hüllkörper.

Die Herstellung von Drähten oder Bändern aus klassischen Supraleitern, wie insbesondere NbSn-Legierungen, ist bekannt. Nach der Entdeckung der neuen, hochtemperatur-supraleitenden Materialien (HTSL) sind bereits auch Vorschläge gemacht worden, diese zu Drähten oder Bändern zu verarbeiten. Beispielsweise wird in der älteren deutschen Patentanmeldung DE-A-3 721 147 vorgeschlagen, daß zunächst ein homogenes supraleitendes Material feinkörnig zermahlen wird, daß das feinkörnige Material in geeignete Hüllkörper, z.B. Rohre oder Taschen, aus hochkaltverformbaren Metallen gefüllt wird und daß die gefüllten Hüllkörper durch Kaltverformung auf den gewünschten Querschnitt gebracht werden. Dabei sollen insbesondere die Verfahrensschritte Zermahlen, Pressen, Sintern und Wärmebehandlung vor dem Einfüllen in die Hüllkörper so oft wiederholt werden, bis die gewünschte Homogenität und Supraleitfähigkeit des Materials erreicht sind. Weitere Verfahren zur Herstellung von Drähten oder Bändern aus HTSL-Materialien sind im Jap. J. of Appl. Phys., Teil 2, Band 26, Supll. 26-3, 1987, Seiten 1207 - 1028 und Band 26, No. 5, Mai 1987, Seiten L 759 - L 760 veröffentlicht.

Problematisch ist bei den bisher hergestellten Drähten und Bändern aus HTSL-Materialien die Stromtragfähigkeit, die im allgemeinen noch nicht den Bedürfnissen der Praxis entspricht. Üblicherweise erfolgt bei den bisherigen Leitermaterialien die Herstellung durch Verformung der Pulver bei Raumtemperatur, wodurch im wesentlichen nur eine Verdichtung erreicht wird.

Aufgabe der Erfindung ist es daher, Herstellverfahren zu schaffen, durch das die Stromtragfähigkeit der erzeugten Drähte und/oder Bänder verbessert wird.

Die Aufgabe ist erfindungsgemäß durch die Kombination folgender Verfahrensschritte gelöst:

a) durch isostatisches Pressen wird das Pulver verdichtet und ein Rohling hergestellt;

b) der Rohling wird bei einer Temperatur $\geqq 500°C$ in einem metallischen Hüllkörper mit einem Umformgrad von mindestens 90 % stranggepreßt;

c) anshließend erfolgt die Weiterverarbeitung des stranggepreßten Rohlings zum Draht oder Band.

Bei der Erfindung kann nach Verfahrensschritt a) vor dem Strangpressen eine zusätzliche Wärmebehandlung des Rohlinges erfolgen. Das isostatische Pressen kann kaltisostatisch (sag. CIP-Verfahren) oder auch heißisostatisch (sog. HIP-Verfahren) durchgeführt werden. Das Strangpressen kann alternativ als Vorwärts-, Rückwärts- oder auch durch isostatisches Strangpressen erfolgen.

Das erfindungsgemäße Verfahren kann mit hochtemperatur-supraleitenden Materialien auf der Basis von Vierstoffsystemen, wie insbesondere Yttrium-Barium-Kupfer-Sauerstoff (Y-Ba-Cu-O) und Lanthan-Strontium-Kupfer-Sauerstoff (La-Sr-Cu-O), oder auf der Basis von Fünfstoffsystemen, wie insbesondere Wismut-Strontium-Calcium-Kupfer-Sauerstoff (Bi-Sr-Ca-Cu-O) und Thallium-Barium-Calcium-Kupfer-Sauerstoff (Tl-Ba-Ca-Cu-O) realisiert werden. Konkrete Untersuchungen wurden speziell an Y-Ba-Cu-O-Materialien durchgeführt.

Im Rahmen der Erfindung wurde gefunden, daß speziell durch die Warmverformung der hochtemperatur-supraleitenden (HTSL-)Materialien eine Erhöhung der Stromtragfähigkeit erreicht wird, da durch das Strangpressen eine gezielte Ausrichtung der Kristallite erreicht wird. Entscheidend ist dabei speziell bei Y-Ba-Cu-O-Materialien das Vorliegen der tetragonalen Phase im supraleitenden Material bei einer Verformung bei Temperaturen ab 700°C. Gemäß der Veröffentlichung "X-Ray Studies of Helium-quenched $Ba_2YCu_3O_{7-x}$" aus ADVANCED CERAMIC MATERIALS VOL. 2, No. 3 B, Special Issue (1987), p. 624-631, mit $o<x=\delta<0,5$ erfolgt bei diesem Material eine Umwandlung von der orthorhombischen Struktur in die tetragonale Struktur bei etwa 700°C. Während des Strangpressens bei der erhöhten Temperatur darf keine Reaktion mit dem Hüllkörper erfolgen, was insbesondere durch Zwischenlage einer Silberfolie zwischen HTSL-Rohling und dem metallischen Hüllkörper, der aus einer Kupferhülle mit eingepaßter Stahlhülse besteht, erreicht wird.

In obigem Zusammenhang ist es wichtig, daß zunächst durch das kalt- oder heißisostatische Pressen ein HTSl-Rohling mit geringer Restporigkeit hergestellt wird, so daß ein anschließendes Strangpressen möglich ist. Dazu werden die pulverförmigen Ausgangsmaterialien nach dem CIP-Verfahren in einem Gummischlauch bei vorzugsweise 2000 bis 3000 bar oder nach dem HIP-Verfahren in einem Hüllrohr aus Silber oder silberbeschichtetem Stahl bei vorzugsweise 900°C und 2000 bar verdichtet. Derart hergestellte Rohlinge können in einem für das Strangpressen geeigneten Hüllkörper mit einem Umformgrad von mindestens 90 % in einem Umformschritt verformt werden. Die anschließende Weiterverarbeitung zur Herstellung der Drähte oder Bänder erfolgt in bekannter Weise durch Hämmern, Ziehen und/oder Walzen.

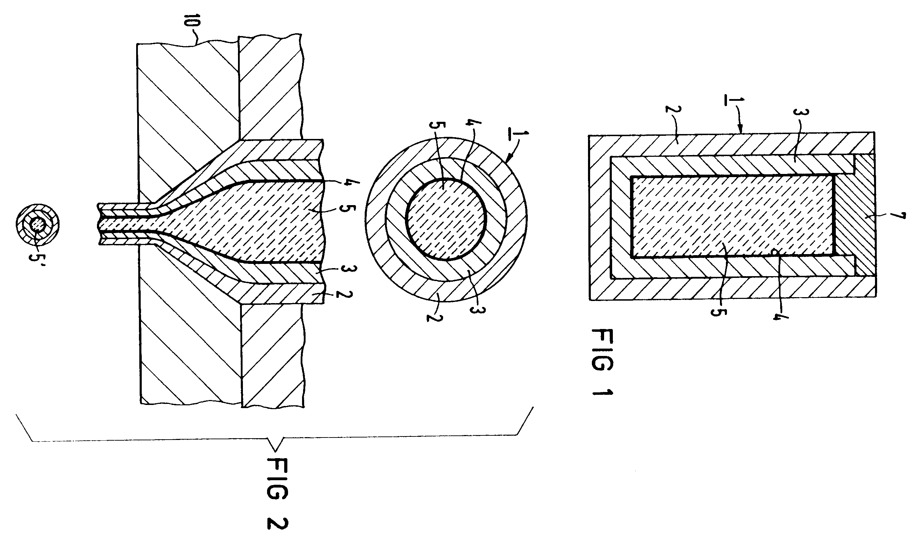

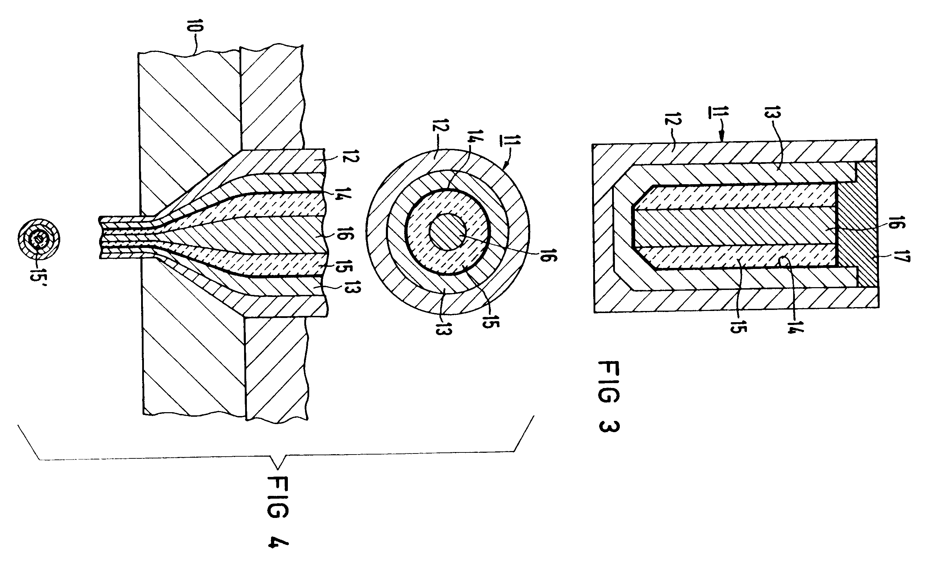

Weitere Einzelheiten und Varteile der Erfindung ergeben sich aus der nachfolgenden Beschreibung von Ausführungsbeispielen in Verbindung mit den Patentansprüchen, wobei weiter unten auf Figuren Bezug genommen wird. Dabei zeigen Fig. 1 und Fig. 3 zwei unterschiedlich aufgebaute Hüllkörper mit HTSL-Rohling in Schnittdarstellung sowie Fig. 2 und Fig. 4 das jeweils beim Strangpressen sich ausbildende Halbzeug mit zugehörigem Preßrest.

Beispiel 1

Bereits supraleitendes HTSL-Keramikpulver auf der Basis des Vierstoffsystemes Yttrium-Barium-Kupfer-Oxid mit der stöchiometrischen Zusammensetzung $YBa_2Cu_3O_{7-\delta}$ und einer Teilchengrößenverteilung 10 bis 200 μm wird in einen Gummischlauch eingefüllt und einem kaltisostatischem Pressen, dem sogenannten CIP-Verfahren, unterzogen. Das Pressen erfolgt bei 2500 bar. Anschließend wird der so hergestellte Rohling für 20 Stunden bei 900°C getempert, wobei das Tempern in einer sauerstoffhaltigen Atmosphäre erfolgt. Der Rohling wird dann in eine für das Strangpressen geeignete metallischen Hüllkörper eingebracht und bei 850°C mit einem Umformgrad von etwa 90 % stranggepreßt. Das heißt, daß ein Rohling mit einem Ausgangsdurchmesser von beispielsweise 50 mm in einem Umformschritt auf 14 mm verformt wird. Schließlich erfolgt eine weitere Verarbeitung zu Drähten und/oder Bändern, in bekannter Weise durch Hämmern, Ziehen und/oder Walzen.

Beispiel 2

Es wird entsprechend Beispiel 1 vorgegangen, wobei das Tempern bei 900°C nach dem kaltisostatischen Pressen entfällt.

Beispiel 3

HTSL-Keramikpulver wie in Beispiel 1 wird in ein Hüllrohr aus Silber oder mit silberbeschichtetem Stahl eingefüllt. Es erfolgt ein heißisostatisches Pressen (das sog. HIP-Verfahren) bei 900°C und einem Druck von etwa 2000 bar. Der so hergestellte Rohling wird anschließend bei einer Temperatur zwischen 800 und 850°C entsprechend Beispiel 1 in einem Umformschritt stranggepreßt. Die sich anschließende Weiterbearbeitung erfolgt wiederum in bekannter Weise durch Hämmern, Ziehen und/oder Walzen.

Beispiel 4

Es wird entsprechend Beispiel 1 vorgegangen, wobei beim kaltisostatischen Pressen in den Rohling ein Silberkern eingebracht wird. Dieser HTSL-Rohling wird ganz entsprechend in einem Hüllkörper stranggepreßt und weiterverarbeitet, wodurch sich ein mit einer HTSL-Schicht versehener Silberdraht erzeugen läßt.

Das Strangpressen des HTSL-Rohlings kann alternativ als sog. Vorwärtsstrangpressen, Rückwärtsstrangpressen (sog. indirektes Strangpressen) oder auch als isostatisches Strangpressen erfolgen. Entscheidend ist dabei, daß bei der Warmverformung eine Ausrichtung der Kristallite erfolgt. Dabei muß dafür Sorge getragen werden, daß ein geeigneter Hüllkörper gleichermaßen die Schmierung in der Pressmatrize und die Führung des Rohlings gewährleistet, so daß die Verformung ohne Reißen der Probe sichergestellt ist.

Bei den Beispielen 1 bis 4 hat sich als Hüllkörper insbesondere ein Kupfermantel mit darin eingepaßter Stahlhülse als geeignet erwiesen, wobei die Stahlhülse an ihrer Innenseite, d.h. zum HTSL-Rohling hin, mit einer Silberschicht versehen ist, um Reaktionen mit dem keramischen Material auszuschließen. Die Silberschicht kann durch übliches Versilbern oder auch durch Zwischenlage einer Silberfolie realisiert werden.

In Fig. 1 ist ein derartiger Hüllkörper für einen HTSL-Rohling 5 mit 1 bezeichnet. Er besteht aus einem napfartigen Kupfermantel 2, in dem eine Stahlhülse 3 eingepaßt ist. Die Stahlhülse hat innenseitig zum HTSL-Rohling 5 eine Silberschicht 4.

Nach Einbringen des Rohlings 5 in den Hüllkörper 1 wird dieser durch einen Deckel 7 abgeschlossen. Beim Strangpressen in einer Strangpreßmatrize 10 gemäß Fig. 2 oder Fig. 4 wird eine Verjüngung des Rohlinges erreicht. Bei einem Umformgrad von mehr als 90 % läßt sich ein Halbzeug erzeugen, das für weitere übliche Formgebungsverfahren geeignet ist.

In der Fig. 3 ist ein Hüllkörper mit 11 bezeichnet. Er besteht entsprechend Fig. 1 aus einem taschenartigen Kupfermantel 12 mit darin eingepaßter Stahlhülse 13 und Silberschicht 14. Kupfermantel 12 und Stahlhülse 13 haben im proximalen Bereich eine spezielle Ausformung, die beim Strangpressen ein Reißen des Mantels verhindern. Eine entsprechende Form hat in diesem Bereich der Rohling 15. Zusätzlich ist im Rohling ein Silberkern 16 eingebettet, der die Verformbarkeit günstig beeinflußt und im Draht oder Band als Endprodukt eine Silberseele realisiert. Dadurch wird die Duktilität des Endproduktes verbessert.

Durch das Strangpressen ergibt sich gemäß Fig. 2 bzw. Fig. 4 ein Halbzeug mit den HTSL-Bereichen 5′ bzw. 15'. Nach dem Strangpressen oder den weiteren Bearbeitungsschritten kann die metallische Außenschicht abgetragen werden, beispielsweise durch Drehen oder Ätzen.

Es hat sich gezeigt, daß die nach dem beschriebenen Verfahren hergestellten Drähte oder Bänder hinsichtlich der erreichbaren Stromtragfähigkeit gegenüber bisher bekannten Drähten oder Bändern verbessert sind.

Das erfindungsgemäße Verfahren wurde in den Beispielen am Ausgangsmaterial $YBa_2Cu_3O_{7-\delta}$ beschrieben und kann auch an anderen HTSL-Materialien durchgeführt werden. Dabei kann das Yttrium zumindest teilweise durch ein anderes Element aus der Gruppe der seltenen Erden ersetzt werden. Weitere HTSL-Materialien sind beispielsweise $Bi_2Sr_2Ca_{n-1}Cu_nO_x$ oder $Tl_2 Ba_2Ca_{n-1}Cu_nO_y$ mit n = 2 oder 3. Dabei kann das Wismut oder das Thallium teilweise durch Blei ersetzt werden.

## Patentansprüche

1. Verfahren zur Herstellung von Drähten oder bändern aus Hochtemperatur-Supraleitern (HTSL), wobei aus oxidischen Pulvern durch Mischen, Pressen, Sintern und Mahlen sowie thermische behandlung ein supraleitendes Material hergestellt wird, das durch Formgebung auf den gewünschten Querschnitt gebracht wird **gekennzeichnet durch** die Abfolge folgender Verfahrensschritte:

a) durch isostatisches Pressen wird das Pulver verdichtet und ein Rohling hergestellt;

b) der Rohling wird bei einer Temperatur $\geqq 500°C$ innerhalb eines metallischen Hüllkörpers mit einem Umformgrad von mindestens 90 % zu einem Halbzeug stranggepreßt;

c) anschließend erfolgt die Weiterbearbeitung des Halbzeugs zum Draht oder band.

2. Verfahren nach Anspruch 1, **dadurch gekennzeichnet**, daß der Hochtemperatur-Supraleiter (HTSL) auf der basis von Vierstoffsystemen, insbesondere Yttrium-barium-Kupfer-Sauerstoff (Y-ba-Cu-O) oder Lanthan-Strontium-Kupfer-Sauerstoff (La-Sr-Cu-O), gewählt ist.

3. Verfahren nach Anspruch 1, **dadurch gekennzeichnet**, daß der Hochtemperatur-Supraleiter (HTSL) auf der basis von Fünfstoffsystemen, insbesondere Wismut-Strontium-Calcium-Kupfer-Sauerstoff (bi-Sr-Ca-Cu-O) oder Thallium-barium-Calcium-Kupfer-Sauerstoff (Tl-ba-Ca-Cu-O), gewählt ist.

4. Verfahren nach Anspruch 3, **dadurch gekennzeichnet**, daß das Wismut (Bi) oder das Thallium (Tl) teilweise durch blei ersetzt ist.

5. Verfahren nach Anspruch 1, **dadurch gekennzeichnet**, daß nach Verfahrensschritt a) vor dem Strangpressen eine Wärmebehandlung des Rohlings durchgeführt wird.

6. Verfahren nach Anspruch 1, **dadurch gekennzeichnet**, daß das isostatische Pressen gemäß Verfahrensschritt a) bei Raumtemperatur in einem Gummischlauch erfolgt (kaltisostatisches Pressen = sog. CIP-Verfahren).

7. Verfahren nach Anspruch 6, **dadurch gekennzeichnet**, daß beim kaltisostatischen Pressen ein Druck zwischen 2000 und 3000 bar angewandt wird.

8. Verfahren nach Anspruch 1, **dadurch gekennzeichnet**, daß das isostatische Pressen gemäß Verfahrensschritt a) bei erhöher Temperatur unterhalb des Schmelzpunktes der Komponenten des HTSL-Materials in einem metallischen Hüllrohr erfolgt (heißisostatisches Pressen = sog. HIP-Verfahren).

9. Verfahren nach Anspruch 8, wobei als HTSL-Material Y-ba-Cu-O gewählt ist, **dadurch gekennzeichnet**, daß das heißisostatische Pressen bei einer Temperatur zwischen 800 und 900°C und einem Druck zwischen 1000 und 2000 bar erfolgt.

10. Verfahren nach Anspruch 8, **dadurch gekennzeichnet**, daß das metallische Hüllrohr aus Silber oder silberbeschichtetem Stahl besteht.

11. Verfahren nach Anspruch 1, **dadurch gekennzeichnet**, daß bei Verfahrenschritt b) das Strangpressen des Rohlings im metallischen Hüllkörper in einem einzigen Umformschritt erfolgt.

12. Verfahren nach Anspruch 11, **dadurch gekennzeichnet**, daß bei Verfahrensschritt b) ein Vorwärtsstrangpressen angewandt wird.

13. Verfahren nach Anspruch 11, **dadurch gekennzeichnet**, daß bei Verfahrensschritt b) ein Rückwärtsstrangpressen (indirektes Strangpressen) angewandt wird.

14. Verfahren nach Anspruch 11, **dadurch gekennzeichnet**, daß bei Verfahrensschritt b) ein isostatisches Strangpressen angewandt wird.

15. Verfahren nach Anspruch 11, wobei als HTSL-Material Y-Ba-Cu-O gewählt ist, **dadurch gekennzeichnet**, daß das Strangpressen bei einer Temperatur $\geqq 700°C$ durchgeführt wird, bei der $YBa_2Cu_3O_{7-\delta}$ eine tetragonale Struktur hat.

16. Verfahren nach Anspruch 1, **dadurch gekennzeichnet**, daß die sich an das Strangpressen anschließenden weiteren bearbeitungsschritte übliche Formgebungsverfahren sind, beispielsweise Hämmern, Ziehen und/oder Walzen.

17. Hüllkörper zum Strangpressen eines Rohlings bei einem Verfahren zur Herstellung von Drähten oder bändern aus Hochtemperatur-Supraleitern gemäß Anspruch 1 oder einem der Ansprüche 2 bis 16, **dadurch gekennzeichnet**, daß der Hüllkörper (1, 11) zur Aufnahme des Rohlings aus einem Kupfer-Mantel (2, 12) mit darin eingepaßter Stahlhülse (3, 13) und Deckel (7, 17) besteht, die auf ihren zum Rohling (5, 15) zugewandten Flächen mit einer Silberschicht (4, 14) versehen sind.

18. Hüllkörper nach Anspruch 17, **dadurch gekennzeichnet**, daß die Silberschicht (4, 14) eine separat einlegbare Silberfolie ist.

19. Hüllkörper nach Anspruch 17 oder 18, **dadurch gekennzeichnet**, daß konzentrisch im Hüllkörper (11) ein Kern (16) aus Silber angeordnet ist.

## Claims

1. Process for the production of wires or strips from high-temperature superconductors (HTSC), wherein a superconductive material is produced from oxidic powders by mixing, compressing, sintering and grinding as well as by thermal treatment, and is brought to the desired cross-section by shaping, characterised by the sequence of the following process steps:

a) by isostatic compressing the powder is compacted and a blank is produced;

b) the blank is extruded to form a semi-finished product at a temperature of $\geq 500°C$ within a metallic casing member with a degree of deformation of at least 90%;

c) subsequently the semi-finished product is processed further to form the wire or strip.

2. Process according to claim 1, characterised in that the high-temperature superconductor (HTSC) is selected on the basis of four-component systems, in particular yttrium-barium-copper-oxygen (Y-Ba-Cu-O) or lanthanum-strontium-copper-oxygen (La-Sr-Cu-O).

3. Process according to claim 1, characterised in that the high-temperature superconductor (HTSC) is selected on the basis of five-component systems, in particular bismuth-strontium-calcium-copper-oxygen (Bi-Sr-Ca-Cu-O) or thallium-barium-calcium-copper-oxygen (Tl-Ba-Ca-Cu-O).

4. Process according to claim 3, characterised in that the bismuth (Bi) or the thallium (Tl) is partially replaced by lead.

5. Process according to claim 1, characterised in that according to process step a) a thermal treatment of the blank is carried out before the extrusion.

6. Process according to claim 1, characterised in that the isostatic compression according to process step a) takes place at room temperature in a rubber tube (cold isostatic compression = so-called CIP process).

7. Process according to claim 6, characterised in that during the cold isostatic compression a pressure of between 2000 and 3000 bar is applied.

8. Process according to claim 1, characterised in that the isostatic compression according to process step a) takes place in a metallic casing tube at an elevated temperature below the melting point of the components of the HTSC material (hot isostatic compression = so-called HIP process).

9. Process according to claim 8, whereby Y-Ba-Cu-O is selected as the HTSC material, characterised in that the hot isostatic compression takes place at a temperature of between 800 and 900°C and a pressure of between 1000 and 2000 bar.

10. Process according to claim 8, characterised in that the metallic casing tube is silver or a silver-coated steel.

11. Process according to claim 1, characterised in that in the case of process step b) the extrusion of the blank in the metallic casing member takes place in a single deformation step.

12. Process according to claim 11, characterised in that in the case of process step b) a forward extrusion is employed.

13. Process according to claim 11, characterised in that in the case of process step b) a reverse extrusion (indirect extrusion) is employed.

14. Process according to claim 11, characterised in that in the case of process step b) an isostatic extrusion is employed.

15. Process according to claim 11, wherein Y-Ba-Cu-O is selected as the HTSC material, characterised in that the extrusion is carried out at a temperature of $\geq 700°C$, at which $YBa_2Cu_3O_{7-\delta}$ has a tetragonal structure.

16. Process according to claim 1, characterised in that the additional process steps following the extrusion process are conventional shaping steps, for instance hammering, drawing and/or rolling.

17. A casing member for extruding a blank in a process for producing wires or strips from high-temperature superconductors according to claim 1 or one of claims 2 to 16, characterised in that the casing member (1, 11) for holding the blank consists of a copper cover (2, 12) with a steel casing (3, 13) fitted therein, and a cover (7, 17) which are provided on their sides facing the blank (5, 15) with a silver layer (4, 14).

18. A casing member according to claim 17, characterised in that the silver layer (4, 14) is a separately insertable silver foil.

19. A casing member according to claim 17 or 18, characterised in that a core (16) of silver is arranged concentrically in the casing member (11).


**Revendications**

1. Procédé pour fabriquer des fils ou des bandes constitués par des supraconducteurs à haute température (HTSL), et selon lequel on fabrique, à partir de poudres d'oxydes, par mélange, pressage, frittage, broyage et traitement thermique, un matériau supraconducteur que l'on amène par formage, à avoir une section transversale désirée, caractérisé par la séquence des étapes opératoires suivantes :

a) on tasse la poudre au moyen d'une compression isostatique et on forme une ébauche;

b) on extrude l'ébauche à une température $\geqq$ 500°C à l'intérieur d'un corps à enveloppe métallique avec un degré de déformation d'au moins 90 %, de manière à obtenir un produit semi-fini;

c) on réalise ensuite le traitement ultérieur du produit semi-fini pour former un fil ou une bande.

2. Procédé suivant la revendication 1, caractérisé par le fait qu'on choisit le supraconducteur à haute température (HTSL) sur la base de systèmes à quatre constituants, notamment yttrium-baryum-cuivre-oxygène (Y-Ba-Cu-O) ou lanthane-strontium-cuivre-oxygène (La-Sr-Cu-O).

3. Procédé suivant la revendication 1, caractérisé par le fait qu'on choisit le supraconducteur à haute température (HTSL) sur la base de systèmes à cinq constituants, notamment bismuth-strontium-calcium-cuivre-oxygène (Bi-Sr-Ca-Cu-O) ou thallium-baryum-calcium-cuivre-oxygène (Tl-Ba-Ca-Cu-O).

4. Procédé suivant la revendication 3, caractérisé par le fait qu'on remplace le bismuth (Bi) ou le thallium (Tl) en partie par du plomb.

5. Procédé suivant la revendication 1, caractérisé par le fait qu'après l'étape opératoire a) et avant l'extrusion, on applique un traitement thermique à l'ébauche.

6. Procédé suivant la revendication 1, caractérisé par le fait que la compression isostatique conforme à l'étape opératoire a) est réalisée à la température ambiante dans un tuyau de caoutchouc (compression isostatique à froid = ce qu'on appelle procédé CIP).

7. Procédé suivant la revendication 6, caractérisé par le fait que lors de la compression isostatique à froid, on applique une pression comprise entre 2000 et 3000 bars.

8. Procédé suivant la revendication 1, caractérisé par le fait que la compression isostatique selon l'étape opératoire a) est exécutée à une température accrue au-dessous du point de fusion des constituants du matériau (HTSL), dans un tube enveloppe métallique (compression isostatique à chaud = ce qu'on appelle procédé HIP).

9. Procédé suivant la revendication 8, selon lequel on choisit comme matériau (HTSL) du Y-Ba-Cu-O, caractérisé par le fait que la compression isostatique à chaud s'effectue à une température comprise entre 800 et 900°C et à une pression comprise entre 1000 et 2000 bars.

10. Procédé suivant la revendication 8, caractérisé par le fait que le tube enveloppe métallique est constitué par de l'argent ou de l'acier plaqué d'argent.

11. Procédé suivant la revendication 1, caractérisé par le fait que lors de l'étape opératoire b), l'extrusion de l'ébauche dans le corps enveloppe métallique s'effectue en une seule étape de formage.

12. Procédé suivant la revendication 1, caractérisé par le fait que lors de l'étape opératoire b), on met en oeuvre une extrusion directe.

13. Procédé suivant la revendication 1, caractérisé par le fait que lors de l'étape opératoire b), on met en oeuvre une extrusion rétrograde (extrusion indirecte).

14. Procédé suivant la revendication 11, caractérisé par le fait que lors de l'étape opératoire b), on met en oeuvre une extrusion isostatique.

15. Procédé suivant la revendication 11, selon lequel on choisit comme matériau HTSL, du Y-Pa-Cu-O, caractérisé par le fait qu'on exécute l'extrusion à une température $\geqq$ 700°C, à laquelle le $YBa_2Cu_3O_7$ possède une structure tétragonale.

16. Procédé suivant la revendication 1, caractérisé par le fait que les autres étapes de traitement, qui succèdent à l'extrusion, sont des procédés usuels de formage, par exemple par martelage, étirage et/ou laminage.

17. Corps enveloppe pour extruder une ébauche selon un procédé pour fabriquer des fils ou des bandes formés de supraconducteurs à haute température suivant la revendication 1 ou l'une des revendications 2 à 16, caractérisé par le fait que le corps enveloppe (1,11) servant à recevoir l'ébauche est constitué par une enveloppe de cuivre (2,12) dans laquelle est insérée une douille en acier (3,13), et par un couvercle (16,17), qui comportent, sur leurs surfaces tournées vers l'ébauche (5,15), une couche d'argent (4,14).

18. Corps enveloppe suivant la revendication 17, caractérisé par le fait que la couche d'argent (4,14) est une feuille d'argent pouvant être insérée séparément.

19. Corps enveloppe suivant la revendication 17 ou 18, caractérisé par le fait qu'un noyau (16) en argent est disposé concentriquement dans le corps enveloppe (11).

FIG 1

FIG 2

FIG 3

FIG 4